# EUROPEAN PATENT APPLICATION

(11) **EP 4 567 447 A1**
(43) Date of publication of application: **11.06.2025**
(21) Application number: 23865820.7
(22) Date of filing: 12.09.2023
(51) Int. Cl.: G01R 31/392, G01R 19/165, G01R 19/10, G01R 19/12, G01R 31/3842, G01R 31/367, G01R 31/396, H01M 10/48, B60L 58/16

(54) **BATTERY MANAGEMENT APPARATUS AND OPERATION METHOD THEREFOR**

(30) Priority: 13.09.2022 KR 20220115234
(71) Applicant: LG Energy Solution, Ltd., Seoul 07335 (KR)
(72) Inventor: SONG, Woo Seok, Daejeon 34122 (KR)
(74) Representative: Plasseraud IP
(86) International application number: PCT/KR2023/013618
(87) International publication number: WO 2024/058523

(57) **Abstract**

A battery management apparatus according to an embodiment disclosed herein includes a measuring unit configured to measure a temperature and a voltage of each of a plurality of battery cells and a controller configured to generate first information of each of the plurality of battery cells, based on whether the plurality of battery cells are being charged or discharged and based on a time-specific temperature of each of the plurality of battery cells and a time-specific voltage of each of the plurality of battery cells and determine a deteriorated battery cell among the plurality of battery cells, based on the first information of each of the plurality of battery cells.

## Description

### [TECHNICAL FIELD]

### CROSS-REFERENCE TO RELATED APPLICATION

This application claims priority to and the benefit of Korean Patent Application No. 10-2022-0115234 filed on September 13, 2022, the entire content of which is incorporated herein by reference.

### TECHNICAL FIELD

Embodiments disclosed herein relate to a battery management apparatus and an operating method thereof.

### [BACKGROUND ART]

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

Among battery cells forming a high-voltage battery system, detection of a deteriorated battery cell that may impair the performance and safety of the battery system is required. Currently, there is a method of determining a health state based on an average state of health (SoH) calculated by a battery management system where battery cells are welded and applied in serial/parallel structure, and there is also a method of detecting a deteriorated battery cell based on a temperature of a battery pack/module measured by the battery management system.

### [DISCLOSURE]

### [TECHNICAL PROBLEM]

Embodiments disclosed herein aim to provide a battery management apparatus and an operating method thereof in which a voltage of a battery cell and a temperature of the battery cell may be collectively considered to determine a deteriorated battery cell using a difference in temperature and voltage fluctuations with respect to a time axis.

Technical problems of the embodiments disclosed herein are not limited to the above-described technical problems, and other unmentioned technical problems would be clearly understood by one of ordinary skill in the art from the following description.

### [TECHNICAL SOLUTION]

A battery management apparatus according to an embodiment disclosed herein may include a measuring unit configured to measure a temperature and a voltage of each of a plurality of battery cells and a controller configured to generate first information of each of the plurality of battery cells, based on whether the plurality of battery cells are being charged or discharged and based on a time-specific temperature of each of the plurality of battery cells and a time-specific voltage of each of the plurality of battery cells and determine a deteriorated battery cell among the plurality of battery cells, based on the first information of each of the plurality of battery cells.

In an embodiment, the controller may be further configured to, when the plurality of battery cells are being charged, generate second information by subtracting an initial temperature from the time-specific temperature of each of the plurality of battery cells, generate third information by subtracting an initial voltage from the time-specific voltage of each of the plurality of battery cells and inverting a result negatively, and generate a difference between the second information and the third information as the first information.

In an embodiment, the controller may be further configured to, when the plurality of battery cells are being discharged, generate second information by subtracting an initial temperature from the time-specific temperature of each of the plurality of battery cells, generate third information by subtracting an initial voltage from the time-specific voltage of each of the plurality of battery cells, and generate a difference between the second information and the third information as the first information.

In an embodiment, the controller may be further configured to determine, as the deteriorated battery cell, a battery cell having a time-specific change of the first information being different from other battery cells by a preset value or greater.

In an embodiment, the controller may be further configured to determine, as the deteriorated battery cell, a battery cell having the first information being different from other battery cells by a preset value or greater.

In an embodiment, the measuring unit may be further configured to measure a current flowing through the plurality of battery cells, and the controller may be further configured to determine that the plurality of battery cells are being charged when the current has a positive value and determine that the plurality of battery cells are being discharged when the current has a negative value.

In an embodiment, the controller may be further configured to regenerate the first information based on a time of state change when a state of the plurality of battery cells changes from charging to discharging or from discharging to charging.

In an embodiment, the measuring unit may include a plurality of temperature sensors, and a number of temperature sensors may correspond to a number of battery cells.

An operating method of a battery management apparatus according to an embodiment disclosed herein may include measuring a temperature and a voltage of each of a plurality of battery cells, generating first information of each of the plurality of battery cells, based on whether the plurality of battery cells are being charged or discharged and based on a time-specific temperature of each of the plurality of battery cells and a time-specific voltage of each of the plurality of battery cells, and determining a deteriorated battery cell among the plurality of battery cells, based on the first information of each of the plurality of battery cells.

In an embodiment, the generating of the first information of each of the plurality of battery cells, based on whether the plurality of battery cells are being charged or discharged and based on a time-specific temperature of each of the plurality of battery cells and a time-specific voltage of each of the plurality of battery cells may include determining whether the plurality of battery cells are being charged or discharged, when the plurality of battery cells are being charged, generating second information by subtracting an initial temperature from the time-specific temperature of each of the plurality of battery cells, generating third information by subtracting an initial voltage from the time-specific voltage of each of the plurality of battery cells and inverting a result negatively, and generating a difference between the second information and the third information as the first information.

In an embodiment, the generating of the first information of each of the plurality of battery cells, based on whether the plurality of battery cells are being charged or discharged and based on a time-specific temperature of each of the plurality of battery cells and a time-specific voltage of each of the plurality of battery cells may include determining whether the plurality of battery cells are being charged or discharged, when the plurality of battery cells are being discharged, generating second information by subtracting an initial temperature from the time-specific temperature of each of the plurality of battery cells, generating third information by subtracting an initial voltage from the time-specific voltage of each of the plurality of battery cells, and generating a difference between the second information and the third information as the first information.

In an embodiment, the operating method may further include measuring a current flowing through the plurality of battery cells and determining that the plurality of battery cells are being charged when the current has a positive value and determining that the plurality of battery cells are being discharged when the current has a negative value.

### [ADVANTAGEOUS EFFECTS]

The battery state management apparatus and the operating method thereof according to an embodiment disclosed herein may generate new information based on a voltage of a battery cell and a temperature of the battery cell and determine a deteriorated battery cell based on the generated information.

The battery state management apparatus and the operating method thereof according to an embodiment disclosed herein may determine a deteriorated battery cell by generating information differently based on whether a plurality of battery cells are being charged or discharged.

The battery management apparatus and the operating method thereof according to an embodiment disclosed herein may generate the first information related to the temperature and the voltage of each of the plurality of battery cells and determine the deteriorated battery cell based on the time-specific change amount of the generated first information.

The battery management apparatus and the operating method thereof according to an embodiment disclosed herein may measure the temperature of each of the plurality of battery cells based on a plurality of temperature sensors corresponding to the number of plurality of battery cells and collectively consider the same together with the voltage of each of the plurality of battery cells, thereby more accurately determining the deteriorated battery cell.

Moreover, various effects recognized directly or indirectly from the disclosure may be provided.

### [DESCRIPTION OF DRAWINGS]

FIG. 1 is a block diagram showing a configuration of a general battery pack.
FIG. 2 is a block diagram of a battery management apparatus according to an embodiment disclosed herein.
FIG. 3 shows an example of a plurality of battery cells and a battery management apparatus according to an embodiment disclosed herein.
FIGS. 4 and 5 show an example where a battery management apparatus according to an embodiment disclosed herein generates first information based on charging/discharging to determine a deteriorated battery cell.
FIG. 6 is a flowchart showing an operating method of a battery management apparatus, according to an embodiment disclosed herein.
FIGS. 7 to 8 are flowcharts showing in detail an operating method of a battery management apparatus, according to an embodiment disclosed herein.
FIG. 9 is a block diagram showing a hardware configuration of a computing system for performing an operating method of a battery management apparatus, according to an embodiment disclosed herein.

### [MODE FOR INVENTION]

Hereinafter, embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. The terms defined in a generally used dictionary should be interpreted as having the same meanings as the contextual meanings of the relevant technology and should not be interpreted as having ideal or exaggerated meanings unless they are clearly defined in the present application.

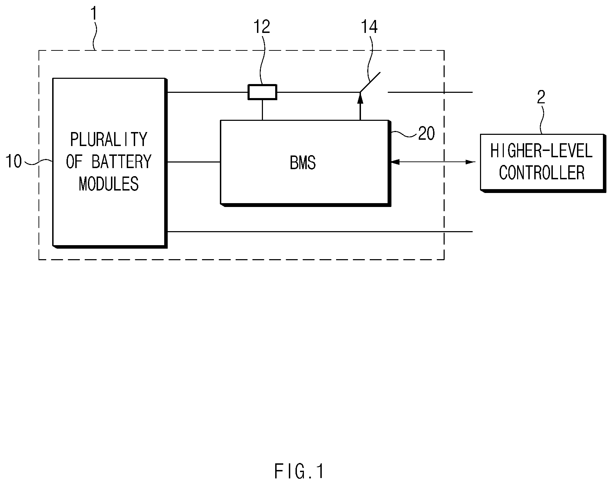

FIG. 1 is a block diagram showing a configuration of a general battery pack.

Referring to FIG. 1, a battery control system including a battery pack 1 and a higher-level controller 2 included in a higher-level system according to an embodiment of the present disclosure is schematically shown.

As shown in FIG. 1, the battery pack 1 may include a battery module 10 that includes one or more battery cells and is chargeable/dischargeable, a switching unit 14 serially connected to a positive (+) terminal side or a negative (-) terminal side of the battery module 10 to control a charging/discharging current flow of the battery module 10, and a battery management system (BMS) 20 for control and management to prevent over-charging and over-discharging by monitoring voltage, current, temperature, etc., of the battery pack 1. The battery pack 1 may include the battery module 10, the sensor 12, the switching unit 14, and the battery management system 20 provided in plural.

Herein, as the switching unit 14 which is an element for controlling a current flow for charging or discharging of the plurality of battery modules 10, for example, at least one relay, magnetic contactor, etc., may be used according to specifications of the battery pack 1.

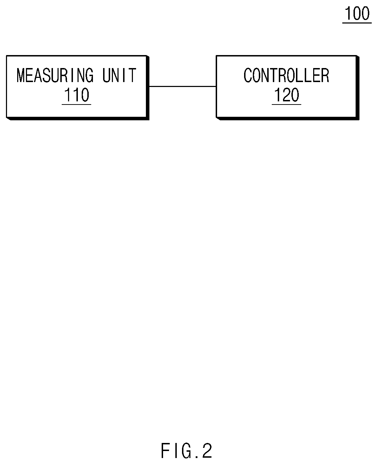

The battery management system 20, which is an interface for receiving measurement values of the above-described various parameter values, may include a plurality of terminals and a circuit, etc., connected thereto to process input values. Moreover, the battery management system 20 may control on/off of the switching unit 14, e.g., a relay, a contactor, etc., and may be connected to the battery module 10 to monitor the state of each battery module 10. According to an embodiment, the battery management system 20 may include a battery management apparatus 100 of FIG. 2. According to another embodiment, the battery management system 20 may be different from the battery management apparatus 100 of FIG. 2. That is, the battery management apparatus 100 of FIG. 2 may be included in the battery pack 1 and may be configured as another device outside the battery pack 1.

The higher-level controller 2 may transmit a control signal regarding the battery module 10 to the battery management system 20. Thus, the battery management system 20 may also be controlled in terms of an operation thereof based on a signal applied from the higher-level controller 2.

FIG. 2 is a block diagram of a battery management apparatus according to an embodiment disclosed herein.

Referring to FIG. 2, the battery management apparatus 100 according to an embodiment disclosed herein may include a measuring unit 110 and a controller 120. Depending on an embodiment, the battery management apparatus 100 may be included in the battery management system 20 of FIG. 1 or may be another device that is different from the battery management system 20 of FIG. 1.

The measuring unit 110 may measure a temperature and a voltage of each of a plurality of battery cells. For example, the measuring unit 110 may measure the temperature and the voltage of each of the plurality of battery cells at specific time intervals. According to an embodiment, the measuring unit 110 may include a temperature sensor and a voltage sensor.

According to an embodiment, the measuring unit 110 may further include a current sensor. For example, the measuring unit 110 may measure a current of the plurality of battery cells.

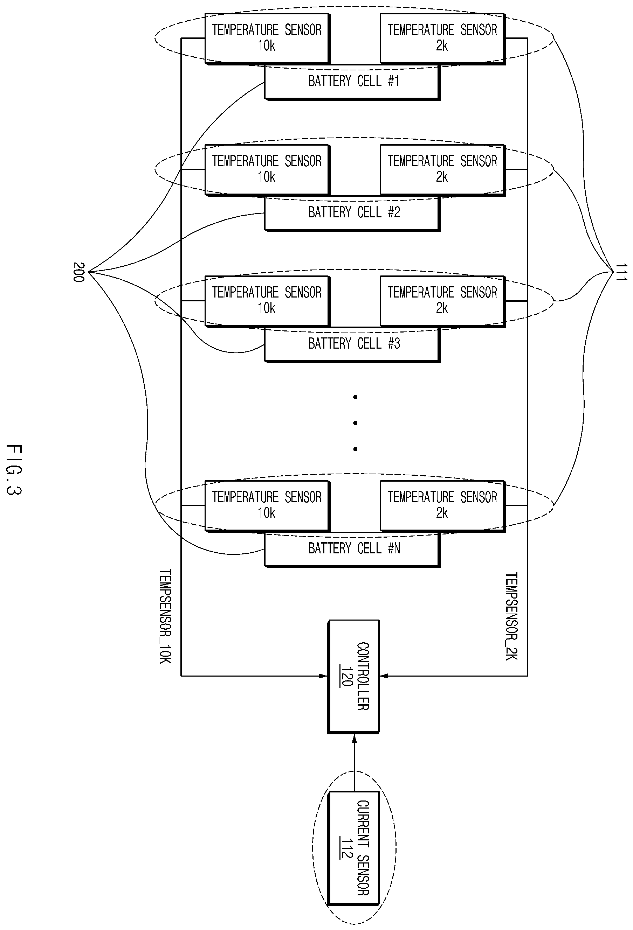

FIG. 3 shows an example of a plurality of battery cells and a battery management apparatus according to an embodiment disclosed herein.

Referring to FIG. 3, the battery management apparatus according to an embodiment disclosed herein may include a plurality of temperature sensors 111, a current sensor 112, and a controller 120. According to an embodiment, the plurality of temperature sensors 111 and the current sensor 112 may be included in the measuring unit 110 of FIG. 2. According to an embodiment, the controller 120 may be substantially the same as the controller 120 of FIG. 2.

The number of temperature sensors included in the plurality of temperature sensors 111 may correspond to the number of battery cells. For example, a specific number of temperature sensors may be attached to each of the plurality of battery cells 200. While it is shown in FIG. 3 that two temperature sensors (temperature sensor 2k a nd temperature sensor 10k) capable of respectively measuring temperatures of 2K and 10K of the plurality of battery cells 200 are attached, the number of temperature sensors may be equal to the number of battery cells, without being limited thereto.

Information measured in the plurality of temperature sensors 111 and the current sensor 112 may be transmitted to the controller 120. The controller 120 may determine based on information received from the plurality of temperature sensors 111 and the current sensor 112 whether the plurality of battery cells 200 are being charged or discharged, whether there is a deteriorated battery cell among the plurality of battery cells 200, etc.

Referring to FIG. 2, the controller 120 may determine whether each of the plurality of battery cells is being charged or discharged. For example, the controller 120 may determine that the plurality of battery cells are being charged when the current measured in the current sensor has a positive value, and determine that the plurality of battery cells are being discharged when the current has a negative value.

The controller 120 may generate first information of each of the plurality of battery cells, based on whether the plurality of battery cells are being charged or discharged and based on a time-specific temperature of each of the plurality of battery cells and a time-specific voltage of each of the plurality of battery cells. For example, the controller 120 may generate the first information in different manners according to whether the plurality of battery cells are being charged or discharged.

According to an embodiment, when the plurality of battery cells are being charged, the controller 120 may generate second information by subtracting an initial temperature from the time-specific temperature of each of the plurality of battery cells. Moreover, the controller 120 may subtract the initial voltage from the time-specific voltage of each of the plurality of battery cells and invert the result negatively to generate third information. In this case, the controller 120 may generate a difference between the second information and the third information as the first information.

According to an embodiment, when the plurality of battery cells are being discharged, the controller 120 may generate second information by subtracting an initial temperature from the time-specific temperature of each of the plurality of battery cells. Moreover, the controller 120 may subtract the initial voltage from the time-specific voltage of each of the plurality of battery cells to generate the third information. In this case, the controller 120 may generate a difference between the second information and the third information as the first information.

The controller 120 may determine a deteriorated battery cell among the plurality of battery cells, based on the first information of each of the plurality of battery cells. For example, the controller 120 may determine the deteriorated battery cell among the plurality of battery cells by comparing the first information of each of the plurality of battery cells.

According to an embodiment, the controller 120 may determine, as the deteriorated battery cell, a battery cell having a change in the first information with respect to time being different from other battery cells by a preset value or greater.

According to another embodiment, the controller 120 may determine, as the deteriorated battery cell, a battery cell having the first information being different from other battery cells by a preset value or greater.

When a battery cell is deteriorated, an internal resistance may increase and a capacity may be deteriorated, and as the internal resistance increases, a temperature change and a voltage change may increase during charging or discharging, such that the controller 120 may determine the deteriorated battery cell based on a range of change of the first information related to temperature and voltage or a magnitude of the first information.

According to an embodiment, when the state of the plurality of battery cells change from charging to discharging, the controller 120 may regenerate the first information at a time of the state change. For example, as a method of generating the first information differs with a case where the plurality of battery cells are being charged and a case where the plurality of battery cells are being discharged, the controller 120 may regenerate the first information in case of state change.

According to an embodiment, when the state of the plurality of battery cells change from discharging to charging, the controller 120 may regenerate the first information at a time of the state change. For example, as a method of generating the first information differs with a case where the plurality of battery cells are being discharged and a case where the plurality of battery cells are being charged, the controller 120 may regenerate the first information in case of state change.

Thus, the battery management apparatus 100 according to an embodiment disclosed herein may accurately determine a deteriorated battery cell regardless of the case where the plurality of battery cells are being charged and the case where the plurality of battery cells are being discharged.

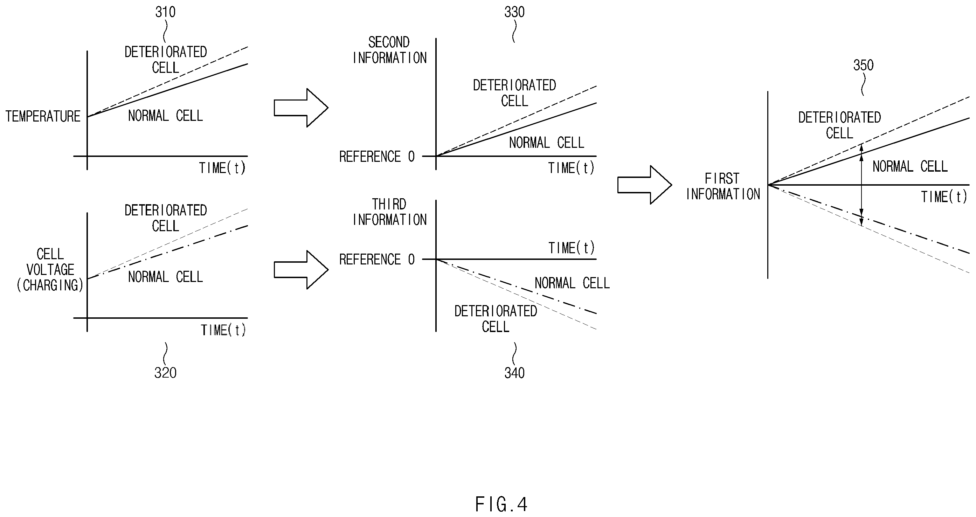

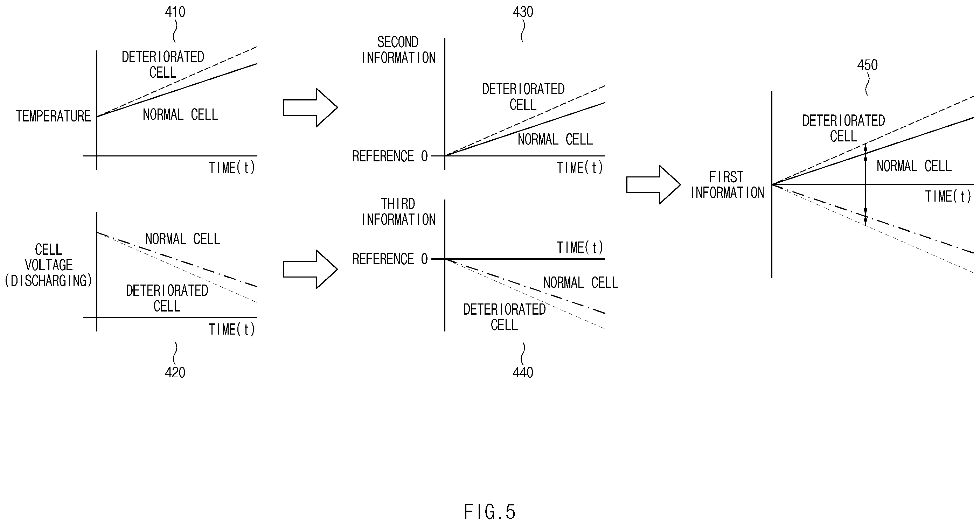

FIGS. 4 and 5 show an example where a battery management apparatus according to an embodiment disclosed herein generates first information based on charging/discharging to determine a deteriorated battery cell.

Referring to FIG. 4, the measuring unit 110 of the battery management apparatus 100 according to an embodiment disclosed herein may measure a current of the plurality of battery cells, and the controller 120 may determine that the plurality of battery cells are being charged.

The measuring unit 110 may measure a time-specific temperature 310 of each of the plurality of battery cells and a time-specific voltage 320 of each of the plurality of battery cells. In this case, a deteriorated battery cell may have a time-specific change in temperature and voltage, being measured greater than a normal battery cell.

The controller 120 may generate the first information based on the time-specific temperature 310 of each of the plurality of battery cells and the time-specific voltage 320 of each of the plurality of battery cells. For example, the controller 120 may subtract the initial temperature from the time-specific temperature 310 of each of the plurality of battery cells to generate second information 330. Moreover, the controller 120 may subtract the initial voltage from the time-specific voltage 320 of each of the plurality of battery cells and invert the result negatively to generate third information 340. In this case, the controller 120 may generate a difference between the second information 330 and the third information 340 as first information 350.

That is, the controller 120 may generate the first information by adjusting the time-specific temperature 310 of each of the plurality of battery cells and the time-specific voltage 320 of each of the plurality of battery cells as the same reference point (e.g., 0).

The controller 120 may determine the deteriorated battery cell based on the generated first information. For example, the controller 120 may determine, as the deteriorated battery cell, a battery cell having a time-specific change amount of the first information being different from other battery cells by a preset value or greater.

Referring to FIG. 5, the measuring unit 110 of the battery management apparatus 100 according to an embodiment disclosed herein may measure a current of the plurality of battery cells, and the controller 120 may determine that the plurality of battery cells are being discharged.

The measuring unit 110 may measure a time-specific temperature 410 of each of the plurality of battery cells and a time-specific voltage 420 of each of the plurality of battery cells. In this case, a deteriorated battery cell may have a time-specific change in temperature and voltage, being measured greater than a normal battery cell.

The controller 120 may generate the first information based on the time-specific temperature 410 of each of the plurality of battery cells and the time-specific voltage 420 of each of the plurality of battery cells. For example, the controller 120 may subtract the initial temperature from the time-specific temperature 410 of each of the plurality of battery cells to generate second information 430. Moreover, the controller 120 may subtract the initial voltage from the time-specific voltage 420 of each of the plurality of battery cells to generate third information 440. In this case, the controller 120 may generate a difference between the second information 430 and the third information 440 as first information 450.

That is, the controller 120 may generate the first information by adjusting the time-specific temperature 410 of each of the plurality of battery cells and the time-specific voltage 420 of each of the plurality of battery cells as the same reference point (e.g., 0).

The controller 120 may determine the deteriorated battery cell based on the generated first information. For example, the controller 120 may determine, as the deteriorated battery cell, a battery cell having a time-specific change amount of the first information being different from other battery cells by a preset value or greater.

According to an embodiment, the battery management apparatus 100 according to an embodiment disclosed herein may generate new information (e.g., first information) by collectively considering temperatures and voltages of the plurality of battery cells and determine the deteriorated battery cell based on the generated information, thereby more accurately determining the deteriorated battery cell than separately using the temperatures or the voltages.

Moreover, the battery management apparatus 100 according to an embodiment disclosed herein may determine the deteriorated battery cell by collectively considering the temperatures and the voltages of the plurality of battery cells, thereby preventing erroneous determination of the deteriorated battery cell due to occurrence of an error in any one of the temperatures or the voltages.

The battery management apparatus according to an embodiment disclosed herein may generate the first information related to the temperature and the voltage of each of the plurality of battery cells and determine the deteriorated battery cell based on the time-specific change amount of the generated first information.

The battery management apparatus according to an embodiment disclosed herein may measure the temperature of each of the plurality of battery cells based on a plurality of temperature sensors corresponding to the number of plurality of battery cells and collectively consider the same together with the voltage of each of the plurality of battery cells, thereby more accurately determining the deteriorated battery cell.

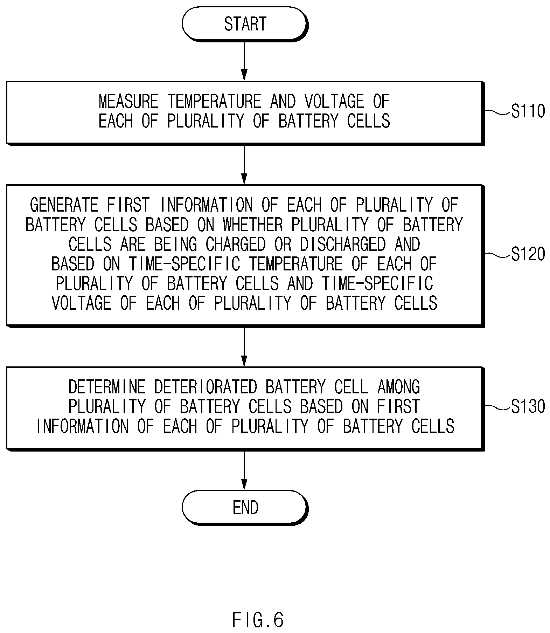

FIG. 6 is a flowchart showing an operating method of a battery management apparatus, according to an embodiment disclosed herein. According to an embodiment, operations shown in FIG. 6 may be performed by the battery management apparatus 100 of FIG. 2.

Referring to FIG. 6, an operating method of the battery management apparatus 100 according to an embodiment disclosed herein may include operation S110 of measuring a temperature and a voltage of each of a plurality of battery cells, operation S120 of generating first information of each of the plurality of battery cells based on whether the plurality of battery cells are being charged or discharged and on a time-specific temperature of each of the plurality of battery cells and a time-specific voltage of each of the plurality of battery cells, and operation S130 of determining a deteriorated battery cell among the plurality of battery cells based on the first information of each of the plurality of battery cells.

In operation S110, the measuring unit 110 may measure the temperature and the voltage of each of the plurality of battery cells. For example, the measuring unit 110 may measure the temperature and the voltage of each of the plurality of battery cells at specific time intervals. According to an embodiment, the measuring unit 110 may include a temperature sensor and a voltage sensor.

In operation S120, the controller 120 may generate the first information of each of the plurality of battery cells, based on whether the plurality of battery cells are being charged or discharged and based on the time-specific temperature of each of the plurality of battery cells and the time-specific voltage of each of the plurality of battery cells. For example, the controller 120 may generate the first information in different manners according to whether the plurality of battery cells are being charged or discharged.

In operation S130, the controller 120 may determine a deteriorated battery cell among the plurality of battery cells, based on the first information of each of the plurality of battery cells. For example, the controller 120 may determine the deteriorated battery cell among the plurality of battery cells by comparing the first information of each of the plurality of battery cells.

According to an embodiment, the controller 120 may determine, as the deteriorated battery cell, a battery cell having a change in the first information with respect to time being different from other battery cells by a preset value or greater.

According to another embodiment, the controller 120 may determine, as the deteriorated battery cell, a battery cell having the first information being different from other battery cells by a preset value or greater.

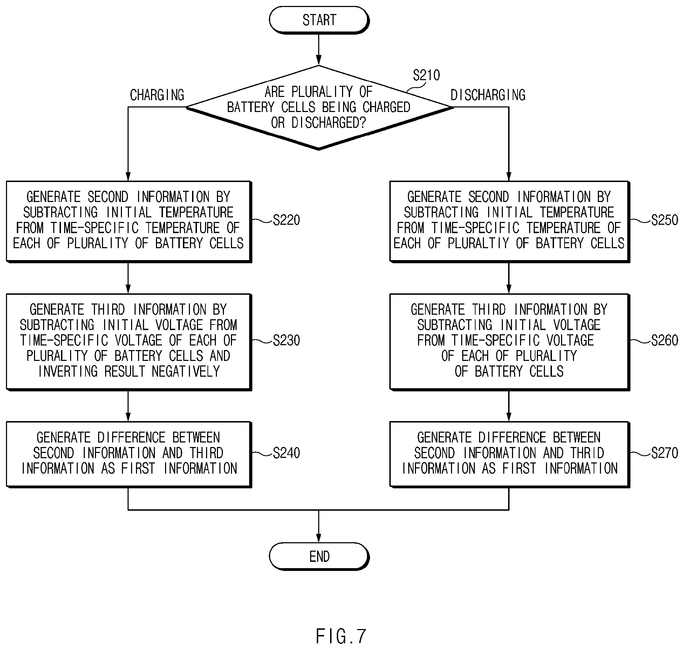

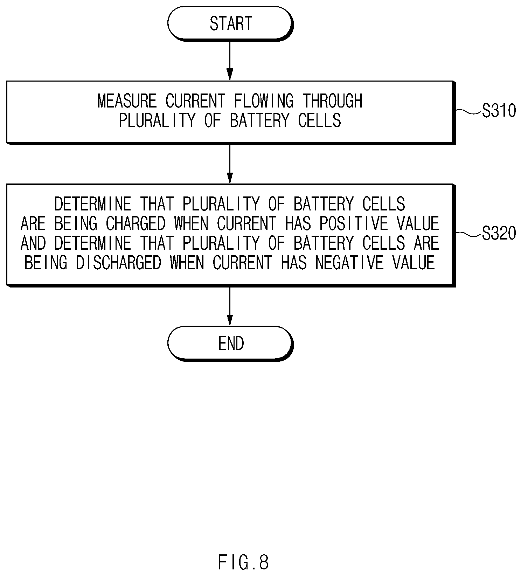

FIGS. 7 to 8 are flowcharts showing in detail an operating method of a battery management apparatus, according to an embodiment disclosed herein. According to an embodiment, operations shown in FIGS. 7 and 8 may be performed by the battery management apparatus 100 of FIG. 2.

Referring to FIG. 7, an operating method of the battery management apparatus 100 according to an embodiment disclosed herein may include operation S210 of determining whether a plurality of battery cells are being charged or discharged, operation S220 of generating second information by subtracting an initial temperature from a time-specific temperature of each of the plurality of battery cells, operation S230 of generating third information by subtracting an initial voltage from a time-specific voltage of each of the plurality of battery cells, operation S240 of generating a difference between the second information and the third information as first information, operation S250 of generating the second information by subtracting the initial temperature from the time-specific temperature of each of the plurality of battery cells, operation S260 of generating the third information by subtracting the initial voltage from the time-specific voltage of each of the plurality of battery cells, and operation S270 of generating a difference between the second information and the third information as the first information.

In operation S210, the controller 120 may determine whether the plurality of battery cells are being charged or discharged. For example, the controller 120 may identify a sign of a current flowing through the plurality of battery cells to determine whether the plurality of battery cells are being charged or discharged. According to an embodiment, the controller 120 may perform operation S220 when the plurality of battery cells are being charged, and perform operation S250 when the plurality of battery cells are being discharged.

In operation S220, the controller 120 may subtract the initial temperature from the time-specific temperature of each of the plurality of battery cells to generate the second information.

In operation S230, the controller 120 may subtract the initial voltage from the time-specific voltage of each of the plurality of battery cells and invert the result negatively to generate third information.

In operation S240, the controller 120 may generate a difference between the second information and the third information as the first information.

According to an embodiment, operations S210 to S240 may be performed through operation S120 of FIG. 6.

In operation S250, the controller 120 may subtract the initial temperature from the time-specific temperature of each of the plurality of battery cells to generate the second information.

In operation S260, the controller 120 may subtract the initial voltage from the time-specific voltage of each of the plurality of battery cells to generate third information.

In operation S270, the controller 120 may generate a difference between the second information and the third information as the first information.

According to an embodiment, operations S210 and S250 to S270 may be performed through operation S120 of FIG. 6.

Referring to FIG. 8, the operating method of the battery management apparatus 100 according to an embodiment disclosed herein may further include operation S310 of measuring a current flowing through the plurality of battery cells and operation S320 of determining that the plurality of battery cells are being charged when the current has a positive value and determining that the plurality of battery cells are being discharged when the current has a negative value.

In operation S310, the measuring unit 110 may measure the current flowing through the plurality of battery cells.

In operation S320, the controller 120 may determine that the plurality of battery cells are being charged when the current has a positive value, and determine that the plurality of battery cells are being discharged when the current has a negative value.

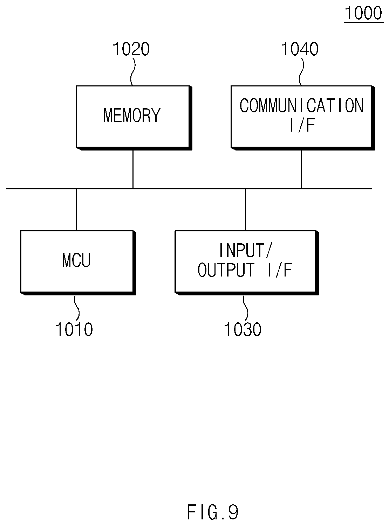

FIG. 9 is a block diagram showing a hardware configuration of a computing system for performing an operating method of a battery management apparatus, according to an embodiment disclosed herein.

Referring to FIG. 9, a computing system 1000 according to an embodiment disclosed herein may include a microcontroller unit (MCU) 1010, a memory 1020, an input/output interface (I/F) 1030, and a communication I/F 1040.

The MCU 1010 may be a processor that executes various programs (e.g., a plurality of battery cell voltage information, current information, or temperature information collection programs, a battery cell charging/discharging determination program, a plurality of battery cell first information generation programs, a deteriorated battery cell determination program, etc.) stored in the memory 1020, processes various information including voltage information of each of the plurality of battery cells, current information of each of the plurality of battery cells, temperature information of each of the plurality of battery cells, first information of each of the plurality of battery cells, whether the battery is deteriorated, etc., through these programs, and performs functions of the controller included in the above-described battery management apparatus shown in FIG. 2.

The memory 1020 may store various programs such as the plurality of battery cell voltage information, current information, or temperature information collection programs, the battery cell charging/discharging determination program, the plurality of battery cell first information generation programs, the deteriorated battery cell determination program, etc. Moreover, the memory 1020 may also store various information such as the voltage information of each of the plurality of battery cells, the current information of each of the plurality of battery cells, the temperature information of each of the plurality of battery cells, the first information of each of the plurality of battery cells, whether the battery is deteriorated, etc.

The memory 1020 may be provided in plural, depending on a need. The memory 1020 may be volatile memory or non-volatile memory. For the memory 1020 as the volatile memory, random access memory (RAM), dynamic RAM (DRAM), static RAM (SRAM), etc., may be used. For the memory 1020 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 1020 are merely examples and are not limited thereto.

The input/output I/F 1030 may provide an interface for transmitting and receiving data by connecting an input device (not shown) such as a keyboard, a mouse, a touch panel, etc., and an output device such as a display (not shown), etc., to the MCU 1010.

The communication I/F 1040, which is a component capable of transmitting and receiving various data to and from a server, may be various devices capable of supporting wired or wireless communication. For example, the battery management apparatus may transmit and receive, from a separately provided external server through the communication I/F 1040, information such as voltage information of each of the plurality of battery cells, current information of each of the plurality of battery cells, temperature information of each of the plurality of battery cells, first information of each of the plurality of battery cells, and whether the battery is deteriorated.

As such, a computer program according to an embodiment disclosed herein may be recorded in the memory 1020 and processed by the MCU 1010, thus being implemented as a module that performs functions shown in FIG. 2.

The above description is merely illustrative of the technical idea of the present disclosure, and various modifications and variations will be possible without departing from the essential characteristics of embodiments of the present disclosure by those of ordinary skill in the art to which the embodiments disclosed herein pertains.

Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of the present disclosure.

## Claims

1. A battery management apparatus comprising:
a measuring unit configured to measure a temperature and a voltage of each of a plurality of battery cells; and
a controller configured to:
generate first information of each of the plurality of battery cells, based on whether the plurality of battery cells are being charged or discharged and based on a time-specific temperature of each of the plurality of battery cells and a time-specific voltage of each of the plurality of battery cells; and
determine a deteriorated battery cell among the plurality of battery cells, based on the first information of each of the plurality of battery cells.

2. The battery management apparatus of claim 1, wherein the controller is further configured to:
when the plurality of battery cells are being charged,
generate second information by subtracting an initial temperature from the time-specific temperature of each of the plurality of battery cells;
generate third information by subtracting an initial voltage from the time-specific voltage of each of the plurality of battery cells and inverting a result negatively; and
generate a difference between the second information and the third information as the first information.

3. The battery management apparatus of claim 1, wherein the controller is further configured to:
when the plurality of battery cells are being discharged,
generate second information by subtracting an initial temperature from the time-specific temperature of each of the plurality of battery cells;
generate third information by subtracting an initial voltage from the time-specific voltage of each of the plurality of battery cells; and
generate a difference between the second information and the third information as the first information.

4. The battery management apparatus of claim 1, wherein the controller is further configured to determine, as the deteriorated battery cell, a battery cell having a time-specific change of the first information being different from other battery cells by a preset value or greater.

5. The battery management apparatus of claim 1, wherein the controller is further configured to determine, as the deteriorated battery cell, a battery cell having the first information being different from other battery cells by a preset value or greater.

6. The battery management apparatus of claim 1, wherein the measuring unit is further configured to measure a current flowing through the plurality of battery cells, and
the controller is further configured to:
determine that the plurality of battery cells are being charged when the current has a positive value; and
determine that the plurality of battery cells are being discharged when the current has a negative value.

7. The battery management apparatus of claim 1, wherein the controller is further configured to regenerate the first information based on a time of state change when a state of the plurality of battery cells changes from charging to discharging or from discharging to charging.

8. The battery management apparatus of claim 1, wherein the measuring unit comprises a plurality of temperature sensors, and
a number of temperature sensors corresponds to a number of battery cells.

9. An operating method of a battery management apparatus, the operating method comprising:
measuring a temperature and a voltage of each of a plurality of battery cells;
generating first information of each of the plurality of battery cells, based on whether the plurality of battery cells are being charged or discharged and based on a time-specific temperature of each of the plurality of battery cells and a time-specific voltage of each of the plurality of battery cells; and
determining a deteriorated battery cell among the plurality of battery cells, based on the first information of each of the plurality of battery cells.

10. The operating method of the battery management apparatus of claim 9, wherein the generating of the first information of each of the plurality of battery cells, based on whether the plurality of battery cells are being charged or discharged and based on a time-specific temperature of each of the plurality of battery cells and a time-specific voltage of each of the plurality of battery cells comprises:
determining whether the plurality of battery cells are being charged or discharged;
when the plurality of battery cells are being charged,
generating second information by subtracting an initial temperature from the time-specific temperature of each of the plurality of battery cells;
generating third information by subtracting an initial voltage from the time-specific voltage of each of the plurality of battery cells and inverting a result negatively; and
generating a difference between the second information and the third information as the first information.

11. The operating method of the battery management apparatus of claim 9, wherein the generating of the first information of each of the plurality of battery cells, based on whether the plurality of battery cells are being charged or discharged and based on a time-specific temperature of each of the plurality of battery cells and a time-specific voltage of each of the plurality of battery cells comprises:
determining whether the plurality of battery cells are being charged or discharg ed;
when the plurality of battery cells are being discharged,
generating second information by subtracting an initial temperature from the time-specific temperature of each of the plurality of battery cells;
generating third information by subtracting an initial voltage from the time-specific voltage of each of the plurality of battery cells; and
generating a difference between the second information and the third information as the first information.

12. The operating method of the battery management apparatus of claim 9, further comprising:
measuring a current flowing through the plurality of battery cells; and
determining that the plurality of battery cells are being charged when the current has a positive value, and determining that the plurality of battery cells are being discharged when the current has a negative value.
